# EUROPEAN PATENT APPLICATION

(11) **EP 4 357 481 A1**
(43) Date of publication of application: **24.04.2024**
(21) Application number: 23202234.3
(22) Date of filing: 06.10.2023
(51) Int. Cl.: C23C 16/04, C23C 16/08, C23C 16/455, H01L 21/285

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 21.10.2022 JP 2022168735
(71) Applicant: Kokusai Electric Corp., Tokyo 1010045 (JP)
(72) Inventor: KURIBAYASHI, Koei, Toyama-shi, Toyama, 9392393 (JP); NOMURA, Kento, Toyama-shi, Toyama, 9392393 (JP); KAGA, Yukinao, Toyama-shi, Toyama, 9392393 (JP)
(74) Representative: Bardehle Pagenberg Partnerschaft mbB Patentanwälte Rechtsanwälte

(57) **Abstract**

According to one embodiment of the present disclosure, there is provided a technique that includes (a) supplying a second-metal-containing gas to a substrate including a first metal film and an insulating film to form a first film containing a second metal on the first metal film; and (b) supplying the second-metal-containing gas to the substrate to form a second film containing the second metal on the first film and the insulating film.

## Description

### CROSS-REFERENCE TO RELATED APPLICATION

This application is based upon and claims the benefit of priority from Japanese Patent Application No. 2022-168735, filed on October 21, 2022, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

In the related art, for example, a low-resistance tungsten (W) film is used as a word line of a NAND flash memory or DRAM having a three-dimensional structure. In addition, for example, a titanium nitride (TiN) film may be used as a barrier film between the W film and an insulating film.

However, since it is difficult to perform etching along with an increase in the number of layers of a NAND flash memory having a three-dimensional structure, the thinning of a word line becomes a problem. In order to solve this problem, there is a demand for a method of forming a metal-based film having good film properties without forming a barrier film as described above.

### SUMMARY

Some embodiments of the present disclosure provide a technique capable of improving the film properties of a metal-based film.

According to one embodiment of the present disclosure, there is provided a technique that includes (a) supplying a second-metal-containing gas, which contains a second metal, to a substrate including a first metal film, which contains a first metal, and an insulating film to form a first film containing the second metal on the first metal film; and (b) supplying the second-metal-containing gas to the substrate to form a second film containing the second metal on the first film and the insulating film.

### BRIEF DESCRIPTION OF DRAWINGS

The accompanying drawings, which are incorporated in and constitute a part of the specification, illustrate embodiments of the present disclosure.
FIG. 1 is a vertical sectional view showing an outline of a vertical process furnace of a substrate processing apparatus according to an embodiment of the present disclosure.
FIG. 2 is a schematic sectional view taken along line A-A in FIG. 1.
FIG. 3 is a schematic configuration diagram of a controller of a substrate processing apparatus according to an embodiment of the present disclosure, in which the control system of the controller is shown in a block diagram.
FIG. 4 is a diagram showing a substrate processing process according to an embodiment of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

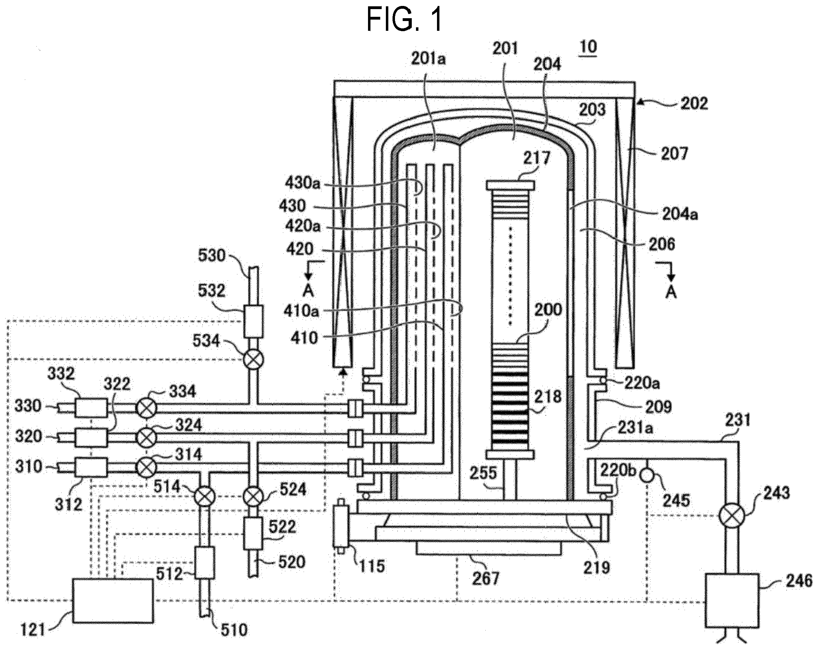

Hereinafter, description will be made with reference to FIGS. 1 to 4. It should be noted that the drawings used in the following description are all schematic, and the relationship between the dimensions of respective elements, the ratio of respective elements, and the like shown in the drawings do not always match the actual ones. Even among the plurality of drawings, the relationship between the dimensions of respective elements, the ratio of respective elements, and the like do not always match.

### (1) Configuration of Substrate Processing Apparatus

The substrate processing apparatus 10 includes a process furnace 202 including a heater 207 as a heating means (a heating mechanism or a heating system). The heater 207 has a cylindrical shape and is vertically installed by being supported by a heater base (not shown) as a holding plate.

Inside the heater 207, an outer tube 203 constituting a reaction tube (a reaction container or a process container) is arranged concentrically with the heater 207. The outer tube 203 is made of a heat-resistant material such as quartz (SiO₂) or silicon carbide (SiC), and is formed in a cylindrical shape with a closed upper end and an open lower end. Below the outer tube 203, a manifold (inlet flange) 209 is arranged concentrically with the outer tube 203. The manifold 209 is made of a metal such as stainless steel (SUS) or the like, and is formed in a cylindrical shape with an open upper end and an open lower end. An O-ring 220a as a sealing member is installed between the upper end portion of the manifold 209 and the outer tube 203. As the manifold 209 is supported on the heater base, the outer tube 203 is installed vertically.

Inside the outer tube 203, an inner tube 204 constituting a reaction container is arranged. The inner tube 204 is made of a heat-resistant material such as quartz or SiC, and is formed in a cylindrical shape with a closed upper end and an open lower end. A process container (reaction container) mainly includes the outer tube 203, the inner tube 204, and the manifold 209. A process chamber 201 is formed in the tubular hollow portion of the process container (inside the inner tube 204).

The process chamber 201 is configured to accommodate wafers 200 as substrates, in such a state that the wafers 200 are arranged in a horizontal posture and in multiple stages along a vertical direction by a boat 217 as a support.

Nozzles 410, 420, and 430 are installed in the process chamber 201 to penetrate the side wall of the manifold 209 and the inner tube 204. Gas supply pipes 310, 320, and 330 are connected to the nozzles 410, 420, and 430, respectively. However, the process furnace 202 of the present embodiment is not limited to the above-described embodiment.

Mass flow controllers (MFCs) 312, 322, and 332, which are flow rate controllers (flow rate control parts) are installed in the gas supply pipes 310, 320, and 330, respectively. Further, valves 314, 324, and 334, which are on-off valves, are installed in the gas supply pipes 310, 320, and 330, respectively. Gas supply pipes 510, 520, and 530 for supplying an inert gas are connected to the gas supply pipes 310, 320, and 330, respectively, on the downstream side of the valves 314, 324, and 334. In the gas supply pipes 510, 520, and 530, MFCs 512, 522, and 532, which are flow rate controllers (flow rate control parts), and valves 514, 524, and 534, which are on-off valves, are installed sequentially from the upstream side.

Nozzles 410, 420, and 430 are connected to the tips of the gas supply pipes 310, 320, and 330, respectively. The nozzles 410, 420, and 430 are configured as L-shaped nozzles, and the horizontal portions thereof are provided so as to penetrate the side wall of the manifold 209 and the inner tube 204. The vertical portions of the nozzles 410, 420, and 430 are installed inside a channel-shaped (groove-shaped) spare chamber 201a formed to protrude outward in the radial direction of the inner tube 204 and to extend in the vertical direction. The vertical portions of the nozzles 410, 420, and 430 are installed in the spare chamber 201a to extend upward (toward the upper side in the arrangement direction of the wafers 200) along the inner wall of the inner tube 204.

The nozzles 410, 420, and 430 are installed to extend from the lower region of the process chamber 201 to the upper region of the process chamber 201. A plurality of gas supply holes 410a, 420a, and 430a is installed at positions of the nozzles 410, 420, and 430, respectively, facing the wafers 200. As a result, processing gases are supplied to the wafers 200 from the gas supply holes 410a, 420a, and 430a of the nozzles 410, 420, and 430. The plurality of gas supply holes 410a, 420a, and 430a is provided from the lower portion to the upper portion of the inner tube 204. The gas supply holes 410a, 420a, and 430a have the same opening area. The gas supply holes 410a, 420a, and 430a are provided at the same opening pitch. However, the gas supply holes 410a, 420a, and 430a are not limited to the above-mentioned form. For example, the opening area may be gradually increased from the lower portion to the upper portion of the inner tube 204. This makes it possible to make the flow rates of the gases supplied from the gas supply holes 410a, 420a, and 430a more uniform.

The plurality of gas supply holes 410a, 420a, and 430a of the nozzles 410, 420, and 430 is provided at height positions from the lower portion to the upper portion of a boat 217, which will be described later. Therefore, the processing gases supplied into the process chamber 201 from the gas supply holes 410a, 420a, and 430a of the nozzles 410, 420, and 430 are supplied to the entire areas of the wafers 200 accommodated from the lower portion to the upper portion of the boat 217. The nozzles 410, 420, and 430 may be installed to extend from the lower region to the upper region of the process chamber 201. Preferably, the nozzles 410, 420, and 430 may be installed to extend to the vicinity of the ceiling of the boat 217.

A precursor gas containing a metal element (also referred to as a metal-containing gas or a second-metal-containing gas) as a processing gas is supplied from the gas supply pipe 310 into the process chamber 201 via the MFC 312, the valve 314, and the nozzle 410.

A reducing gas as a processing gas is supplied from the gas supply pipe 320 into the process chamber 201 via the MFC 322, the valve 324, and the nozzle 420.

A modifying gas as a processing gas is supplied from the gas supply pipe 330 into the process chamber 201 via the MFC 332, the valve 334, and the nozzle 430.

An inert gas, for example, an argon (Ar) gas is supplied from the gas supply pipes 510, 520, and 530 into the process chamber 201 via the MFCs 512, 522, and 532, the valves 514, 524, and 534, and the nozzles 410, 420, and 430, respectively. Hereinafter, an example in which the Ar gas is used as the inert gas will be described. However, as the inert gas, for example, a rare gas such as a helium (He) gas, a neon (Ne) gas, or a xenon (Xe) gas may be used, in addition to the Ar gas.

When the precursor gas is mainly supplied from the gas supply pipe 310, a precursor gas supply system mainly includes the gas supply pipe 310, the MFC 312, and the valve 314. The nozzle 410 may be included in the precursor gas supply system. The precursor gas supply system may also be referred to as a metal-containing gas supply system (second-metal-containing gas supply system). When the reducing gas is supplied from the gas supply pipe 320, a reducing gas supply system mainly includes the gas supply pipe 320, the MFC 322, and the valve 324. The nozzle 420 may be included in the reducing gas supply system. When the modifying gas is supplied from the gas supply pipe 330, a modifying gas supply system mainly includes the gas supply pipe 330, the MFC 332, and the valve 334. The nozzle 430 may be included in the modifying gas supply system. Moreover, the metal-containing gas supply system, the reducing gas supply system, and the modifying gas supply system may also be referred to as processing gas supply systems. The nozzles 410, 420, and 430 may be included in the processing gas supply systems. In addition, an inert gas supply system mainly includes the gas supply pipes 510, 520, and 530, the MFCs 512, 522, and 532, and the valves 514, 524, and 534.

In the gas supply method according to the present embodiment, gases are conveyed via the nozzles 410, 420, and 430 arranged in the spare chamber 201a in the vertically elongated annular space defined by the inner wall of the inner tube 204 and the ends of the plurality of wafers 200. Then, the gases are discharged into the inner tube 204 from the plurality of gas supply holes 410a, 420a, and 430a provided at the positions of the nozzles 410, 420, and 430 facing the wafers. More specifically, the processing gases and the like are discharged in the direction parallel to the surfaces of the wafers 200 by the gas supply holes 410a of the nozzle 410, the gas supply holes 420a of the nozzle 420, and the gas supply holes 430a of the nozzle 430.

The exhaust hole (exhaust port) 204a is a through-hole formed at a position facing the nozzles 410, 420, and 430 on the side wall of the inner tube 204, and is, for example, a slit-shaped through-hole elongated in the vertical direction. The gas supplied into the process chamber 201 from the gas supply holes 410a, 420a, and 430a of the nozzles 410, 420, and 430 and flowing on the surfaces of the wafers 200 passes through the exhaust hole 204a and flows into a gap (exhaust path 206) defined between the inner tube 204 and the outer tube 203. Then, the gas flowing into the exhaust path 206 is allowed to flow into the exhaust pipe 231 and is discharged to the outside of the process furnace 202.

The exhaust hole 204a are provided at a position facing the plurality of wafers 200. The gas supplied from the gas supply holes 410a, 420a, and 430a to the vicinity of the wafers 200 in the process chamber 201 flows in the horizontal direction and then flows into the exhaust path 206 through the exhaust hole 204a. The exhaust hole 204a is not limited to the slit-shaped through-hole, and may be configured by a plurality of holes.

An exhaust pipe 231 for exhausting the atmosphere in the process chamber 201 is installed in the manifold 209. In the exhaust pipe 231, a pressure sensor 245 as a pressure detector (pressure detection part) for detecting the pressure in the process chamber 201, an APC (Auto Pressure Controller) valve 243, and a vacuum pump 246 as a vacuum exhaust device are installed sequentially from the upstream side. By opening and closing the APC valve 243 while operating the vacuum pump 246, it is possible to perform vacuum exhaust and stop vacuum exhaust for the process chamber 201. Further, by adjusting the opening degree of the APC valve 243 while operating the vacuum pump 246, it is possible to regulate the pressure in the process chamber 201. An exhaust system mainly includes the exhaust hole 204a, the exhaust path 206, the exhaust pipe 231, the APC valve 243, and the pressure sensor 245. The vacuum pump 246 may be included in the exhaust system.

Below the manifold 209, a seal cap 219 is installed as a furnace opening lid capable of airtightly closing the lower end opening of the manifold 209. The seal cap 219 is configured to abut on the lower end of the manifold 209 from the lower side in the vertical direction. The seal cap 219 is made of a metal such as SUS or the like, and is formed in a disk shape. An O-ring 220b as a sealing member that comes into contact with the lower end of the manifold 209 is installed on the upper surface of the seal cap 219. On the opposite side of the seal cap 219 from the process chamber 201, a rotator 267 for rotating the boat 217 that accommodates the wafers 200 is installed. The rotary shaft 255 of the rotator 267 penetrates the seal cap 219 and is connected to the boat 217. The rotator 267 is configured to rotate the wafers 200 by rotating the boat 217. The seal cap 219 is configured to be raised and lowered in the vertical direction by a boat elevator 115 as an elevating mechanism vertically installed outside the outer tube 203. The boat elevator 115 is configured to be capable of loading and unloading the boat 217 into and from the process chamber 201 by raising and lowering the seal cap 219. The boat elevator 115 is configured as a transfer device (transfer mechanism or transfer system) for transferring the boat 217 and the wafers 200, which are accommodated in the boat 217, into and out of the process chamber 201.

The boat 217 is configured to arrange a plurality of wafers, for example, 25 to 200 wafers 200, in a horizontal posture and at intervals in the vertical direction with the centers thereof aligned with each other. The boat 217 is made of a heat-resistant material such as quartz or SiC. Below the boat 217, dummy substrates 218 made of a heat-resistant material such as quartz or SiC are installed in a horizontal posture in multiple stages. With this configuration, the heat from the heater 207 is less likely to be transferred to the seal cap 219. However, the present embodiment is not limited to the above-described form. For example, instead of installing the dummy substrates 218 below the boat 217, a heat-insulating cylinder configured as a cylindrical member made of a heat-resistant material such as quartz or SiC may be installed.

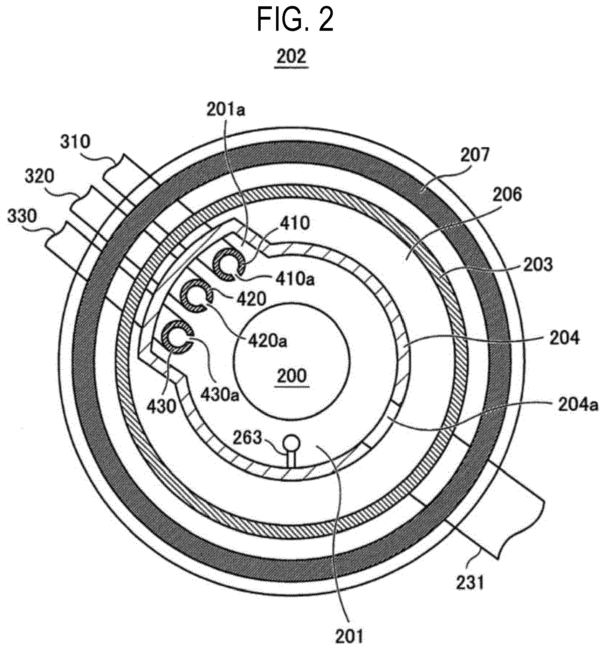

As shown in FIG. 2, a temperature sensor 263 as a temperature detector is installed in the inner tube 204. The amount of electric power supplied to the heater 207 is adjusted based on the temperature information detected by the temperature sensor 263, so that the temperature in the process chamber 201 has a desired temperature distribution. The temperature sensor 263 is formed in an L shape like the nozzles 410, 420, and 430, and is installed along the inner wall of the inner tube 204.

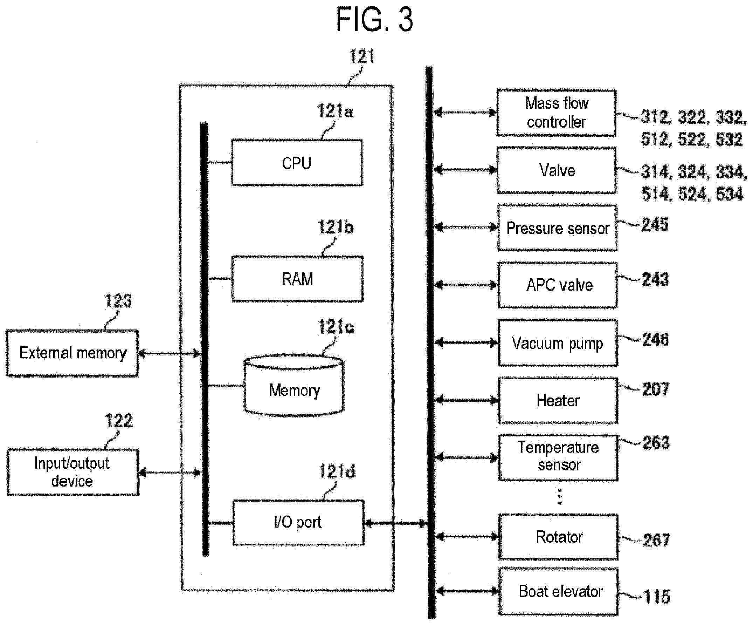

As shown in FIG. 3, the controller 121, which is a control part (control means), is configured as a computer including a CPU (Central Processing Unit) 121a, a RAM (Random Access Memory) 121b, a memory device 121c, and an I/O port 121d. The RAM 121b, the memory device 121c, and the I/O port 121d are configured to exchange data with the CPU 121a via an internal bus. An input/output device 122 configured as, for example, a touch panel or the like is connected to the controller 121.

The memory device 121c is composed of, for example, a flash memory, an HDD (Hard Disk Drive), or the like. The memory device 121c readably stores a control program for controlling the operation of the substrate processing apparatus, a process recipe in which procedures and a condition of the below-described method of manufacturing a semiconductor device (method of processing a substrate) are described, and the like. The process recipe is a combination for causing the controller 121 to execute each step (each step) in the below-described method of manufacturing a semiconductor device (method of processing a substrate) to obtain a predetermined result. The process recipe functions as a program. Hereinafter, the process recipe, the control program, and the like are collectively and simply referred to as a program. When the term program is used in the subject specification, it may include only the process recipe, only the control program, or a combination of the process recipe and the control program. The RAM 121b is configured as a memory area (work area) in which programs, data, and the like read by the CPU 121a are temporarily held.

The I/O port 121d is connected to the MFCs 312, 322, 332, 512, 522, and 532, the valves 314, 324, 334, 514, 524, and 534, the pressure sensor 245, the APC valve 243, the vacuum pump 246, the heater 207, the temperature sensor 263, the rotator 267, the boat elevator 115, and the like.

The CPU 121a is configured to read the control program from the memory device 121c and execute the same. The CPU 121a is also configured to read the recipe or the like from the memory device 121c in response to an input of an operation command from the input/output device 122 or the like. The CPU 121a is configured to be capable of controlling, according to the contents of the recipe thus read, the flow rate adjustment operations for various gases by the MFCs 312, 322, 332, 512, 522, and 532, the opening/closing operations of the valves 314, 324, 334, 514, 524, and 534, the opening/closing operation of the APC valve 243, the pressure regulation operation by the APC valve 243 based on the pressure sensor 245, the temperature adjustment operation of the heater 207 based on the temperature sensor 263, the start and stop of vacuum pump 246, the rotation and rotation speed adjustment operation for the boat 217 by the rotator 267, the raising/lowering operation for the boat 217 by the boat elevator 115, the operation of accommodating the wafers 200 in the boat 217, and the like.

The controller 121 can be configured by installing, in a computer, the above-mentioned program stored in an external memory device 123 (e.g., a magnetic tape, a magnetic disk such as a flexible disk or a hard disk, an optical disk such as a CD or a DVD, a magneto-optical disk such as a MO or the like, and a semiconductor memory such as a USB memory or a memory card). The memory device 121c and the external memory device 123 are configured as a non-transitory computer-readable recording medium. Hereinafter, these are collectively and simply referred to as a recording medium. In the subject specification, the recording medium may include only the memory device 121c, only the external memory device 123, or both of them. The program may be provided to the computer by using a communication means such as the Internet or a dedicated line without using the external memory device 123.

### (2) Substrate Processing Process

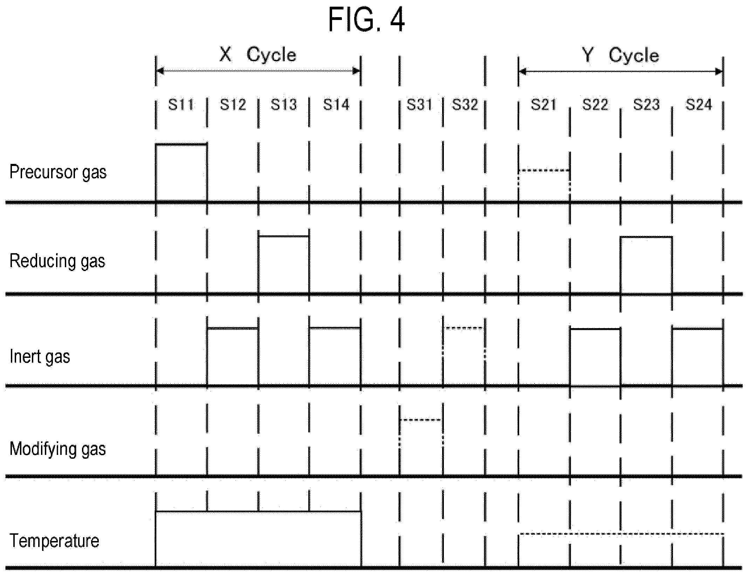

As one process of manufacturing a semiconductor device, an example of a process of forming a film containing a second metal (also referred to as a second metal-containing film) used as, for example, a control gate electrode of a 3D NAND on a wafer 200 will be described with reference to FIG. 4. The process of forming the second metal-containing film is performed using the process furnace 202 of the substrate processing apparatus 10 described above. In the following description, the operation of each part of the substrate processing apparatus 10 is controlled by the controller 121.

The substrate processing process (the semiconductor device manufacturing process) according to the present embodiment includes:
(a) supplying a second-metal-containing gas to a wafer 200 including a first metal film and an insulating film to form a first film containing a second metal on the first metal film; and
(b) supplying the second-metal-containing gas to the wafer 200 to form a second film containing the second metal on the first film and the insulating film,
whereby the first film and the second film containing the second metal are formed on the wafer 200.

When the term "wafer" is used herein, it may refer to "a wafer itself" or "a stacked body of a wafer and a predetermined layer or film formed on the surface of the wafer." When the phrase "a surface of a wafer" is used herein, it may refer to "a surface of a wafer itself" or "a surface of a predetermined layer or the like formed on a wafer." When the term "substrate" is used herein, it may be synonymous with the term "wafer."

### (Wafer Loading)

After a plurality of wafers 200 is charged into the boat 217 (wafer charging), as shown in FIG. 1, the boat 217 supporting the plurality of wafers 200 is raised by the boat elevator 115 and loaded into the process chamber 201 (boat loading), whereby the boat 217 is accommodated in the process container. In this state, the seal cap 219 closes the lower end opening of the outer tube 203 via the O-ring 220.

The wafer 200 includes a first metal film and an insulating film.

The insulating film includes an oxide film, a nitride film, an oxynitride film, an oxycarbide film, an oxycarbonitride film, and the like containing at least one selected from the group of a group 13 element, a group 14 element, and a group 3 element. For example, the insulating film includes an aluminum oxide (AlO) film, a silicon oxide (SiO) film, a titanium oxide (TiO) film, a zirconium oxide (ZrO) film, a hafnium oxide (HfO) film, a silicon nitride (SiN) film, a silicon oxynitride (SiON) film, a silicon oxycarbide (SiOC) film, a silicon oxycarbonitride (SiOCN) film, and the like. The insulating film may be a composite film of these materials or a laminated film of these materials. Si in SiN, SiON, SiOC, and SiOCN described here may be replaced with another Group 13 element, Group 14 element, Group 3 element, or the like.

The first metal film and the insulating film of the wafer 200 may be formed on the same horizontal plane or may be formed on different planes. The term "different planes" refers to, for example, a case where a plurality of recesses are formed in the wafer 200, and the first metal film is formed on the inner surfaces of the recesses with the insulating film formed on the sidewalls of the recesses.

The first metal and the second metal are, for example, each a metal including at least one selected from the group of tungsten (W), titanium (Ti), ruthenium (Ru), cobalt (Co), and molybdenum (Mo). The first metal and the second metal may be elemental metal or compounds containing the same element as a main element. Further, the first metal and the second metal may be elemental metal or compounds containing different elements as main elements. The second-metal-containing gas contains the second metal and one or more halogen elements. The halogen elements are, for example, fluorine (F), chlorine (Cl), bromine (Br), and iodine (I). Specific examples of the second-metal-containing gas include a tungsten hexafluoride (WF₆) gas, a tungsten hexachloride (WCl₆) gas, a molybdenum trichloride (MoCl₃) gas, a molybdenum pentachloride (MoCl₅) gas, a gas containing Mo, oxygen (O) and Cl such as a molybdenum dioxide dichloride (MoO₂Cl₂) gas and a molybdenum oxide tetrachloride (MoOCl₄) gas, a ruthenium hexafluoride (RuF₆) gas, and the like.

In the film formation using such a compound containing a halogen element (simply referred to as a halide in the present disclosure), a reaction may occur in which the halide itself or the reaction by-product generated by using the halide etches (removes) the second metal-containing layer formed on the wafer 200. The generation amount of the etching reaction can be adjusted (controlled) by, for example, a configuration of the wafer 200 to be processed, a gas supply sequence in the substrate processing process, various processing conditions, and the like.

The configuration of the wafer 200 refers to, for example, the type of film present on the surface of the wafer 200 or the structure present on the surface of the wafer 200. For example, depending on the type of film, an etching reaction is more likely to occur on the insulating film than on the metal film. That is, the removal reaction of the second metal-containing layer during formation of the second metal-containing layer is more likely to occur on the insulating film.

The conditions when forming the second metal-containing layer include, for example, a gas supply sequence, a temperature of the wafer 200, and a supply amount of the second-metal-containing gas. By increasing the temperature of the wafer 200 and increasing the reactivity of the second-metal-containing gas, the etching reaction can be easily occurred. It is also effective to set the temperature of the wafer 200 to a temperature at which the decomposition reaction of the second-metal-containing gas can occur. Moreover, by increasing the supply amount of the second-metal-containing gas as one of the conditions, it is possible to cause the etching reaction to occur easily. As used herein, the term "supply amount" refers to at least one selected from the group of the supply flow rate of the second-metal-containing gas, the supply time of the second-metal-containing gas, and the pressure inside the process chamber 201. Further, these may be combined to increase the supply amount of the second-metal-containing gas. For example, the supply amount can be increased by adjusting a product of the supply flow rate and the supply time. Further, as the adjustment of the product of the supply flow rate and the supply time, the supply amount can be increased by increasing at least one selected from the group of the supply flow rate and the supply time.

As a method of reducing the generation amount of the etching reaction or increasing the amount of film-forming reaction over the amount of etching reaction, for example, there is a method of reversely controlling them, or a method of modifying a surface state of the wafer 200.

As the method of modifying the surface state of the wafer 200, for example, there is a method of supplying a modifying gas that promotes or inhibits the adsorption of the second-metal-containing gas onto the surface of the wafer 200, to the wafer 200. By supplying such a modified gas to the wafer 200, at least a part of the modifying gas can be adsorbed onto the wafer 200. The amount of etching reaction can be adjusted (controlled) by adjusting an ease of bonding between at least a part of the adsorbed modifying gas and the second-metal-containing gas. An example of controlling the formation amount (deposition amount) and the etching amount of the second metal-containing layer (second metal-containing film) will be described later.

The adjustment of the formation amount and the etching amount of the second metal-containing layer is effective particularly when the following structure is formed on the wafer 200. As the structure formed on the wafer 200, for example, there is a structure in which a plurality of recesses are formed, a first metal film is exposed on the innermost surfaces of the recesses, and an insulating film is exposed on the sidewall surfaces of the recesses.

Reaction by-products resulting from the use of a halide include, for example, at least one of the following substances. The reaction by-products produced may vary depending on the gas supply sequence and various conditions in the substrate processing process.
A) Halogen produced by decomposition of a halide. Such production occurs, for example, when the temperature of the wafer 200 during the supply of a halide is at a temperature at which the halide is decomposed, or when a gas that decomposes the halide exists in the process chamber 201 or on the surface of the wafer 200.
B) Halogen produced when a halide contacts the surface of wafer 200. Such production occurs, for example, as the halogen contained in a halide is desorbed when the halide comes into contact with the surface of the wafer 200.
C) Halogen produced by the reaction of a halide with a reaction gas (reducing gas). Such production occurs by the reaction between a halide and a reaction gas when the reaction gas is supplied to the halide adsorbed on the surface of the wafer 200. Further, this production may occur when the halide and the reaction gas react with each other in the gas phase inside the process chamber 201.

### (Pressure Regulation and Temperature Adjustment)

The inside of the process chamber 201, i.e., the space where the wafers 200 exist, is vacuum-exhausted by the vacuum pump 246 to have a desired pressure (vacuum degree). At this time, the pressure in the process chamber 201 is measured by the pressure sensor 245, and the APC valve 243 is feedback-controlled based on the measured pressure information (pressure regulation). The vacuum pump 246 is constantly kept in operation until at least the processing for the wafers 200 is completed. Further, the inside of the process chamber 201 is heated by the heater 207 to have a desired temperature. At this time, the amount of electric power supplied to the heater 207 is feedback-controlled based on the temperature information detected by the temperature sensor 263 so that the inside of the process chamber 201 has a desired temperature distribution (temperature adjustment). The inside of the process chamber 201 is continuously heated by the heater 207 at least until the processing on the wafers 200 is completed.

### [Process of Forming First Layer (First Film)]

### [Supply of Second-Metal-Containing Gas, Step S11]

The valve 314 is opened to allow a second-metal-containing gas, which is a precursor gas, to flow into the gas supply pipe 310. The flow rate of the second-metal-containing gas is adjusted by the MFC 312. The second-metal-containing gas is supplied into the process chamber 201 through the gas supply holes 410a of the nozzle 410 and is exhausted through the exhaust pipe 231. At this time, the second-metal-containing gas is supplied to the wafer 200. At the same time, the valve 514 is opened to allow an inert gas such as an Ar gas or the like to flow into the gas supply pipe 510. The flow rate of the Ar gas flowing through the gas supply pipe 510 is adjusted by the MFC 512. The Ar gas is supplied into the process chamber 201 together with the second-metal-containing gas and is exhausted through the exhaust pipe 231. At this time, in order to prevent the second-metal-containing gas from entering the nozzle 420, the valve 524 may be opened to allow an Ar gas to flow into the gas supply pipe 520. The Ar gas is supplied into the process chamber 201 through the gas supply pipe 320 and the nozzle 420 and is exhausted through the exhaust pipe 231.

At this time, the APC valve 243 is adjusted to set the pressure in the process chamber 201 to fall within the range of 1 to 3990 Pa, for example, to 1000 Pa. The supply flow rate of the second-metal-containing gas controlled by the MFC 312 is, for example, 0.1 to 3.0 slm, and may be 0.4 to 2.5 slm. Each of the supply flow rates of the Ar gas controlled by the MFCs 512 and 522 is set to fall within the range of, for example, 0.1 to 20 slm. The time for supplying the second-metal-containing gas to the wafer 200 is, for example, 1 to 60 seconds, and may be 1 to 10 seconds. The temperature of the wafer 200 is set to 300 to 700 degrees C, and may be 500 to 700 degrees C. In the present disclosure, the expression of a numerical range such as "1 to 3990 Pa" means that the lower limit and the upper limit are included in the range. Therefore, for example, "1 to 3990 Pa" means "1 Pa or more and 3990 Pa or less." The same applies to other numerical ranges.

At this time, the gases flowing in the process chamber 201 are only the second-metal-containing gas and the Ar gas. A second metal-containing layer is formed on the wafer 200 by supplying the second-metal-containing gas.

By increasing the supply amount of the second-metal-containing gas to be larger than that in step S21 described later, a first second-metal-containing layer can be formed, by priority, on the first metal film of the wafer 200. As used herein, the expression "the supply amount of the second-metal-containing gas" refers to at least one selected from the group of the flow rate of the second-metal-containing gas, the supply time of the second-metal-containing gas, and the pressure in the process chamber 201 as a space in which the wafer 200 exists. At least one of them is set to be larger than in step S21, which will be described later. In addition, the supply amount of the second-metal-containing gas may be adjusted by combining them.

Further, by setting the temperature of the wafer 200 in the process of forming the first layer (first film) (the temperature in the process chamber 201 as the space in which the wafer 200 exists) to be higher than the temperature of the wafer 200 in a process of forming a second layer (second film), it is possible to promote forming the first second-metal-containing layer, by priority, on the first metal film.

### (Residual Gas Removal, Step S12)

After a predetermined period of time, for example 1 to 60 seconds, has elapsed from the start of the supply of the second-metal-containing gas, the valve 314 of the gas supply pipe 310 is closed to stop the supply of the second-metal-containing gas. At this time, while keeping the APC valve 243 of the exhaust pipe 231 opened, the inside of the process chamber 201 is vacuum-exhausted by the vacuum pump 246 to remove the second-metal-containing gas unreacted or contributed to the formation of the first second-metal-containing layer, which remains in the process chamber 201, from the inside of the process chamber 201. That is, the inside of the process chamber 201 is purged. At this time, the valves 514 and 524 are kept opened to maintain the supply of the Ar gas into the process chamber 201. The Ar gas acts as a purge gas and can enhance the effect of removing the second-metal-containing gas unreacted or contributed to the formation of the first second-metal-containing layer, which remains in the process chamber 201, from the inside of the process chamber 201.

### (First Reducing Gas Supply, Step S13)

After removing the residual gas in the process chamber 201, the valve 324 is opened to allow a first reducing gas to flow into the gas supply pipe 320. The flow rate of the first reducing gas is adjusted by the MFC 322. The first reducing gas is supplied into the process chamber 201 through the gas supply holes 420a of the nozzle 420 and is exhausted through the exhaust pipe 231. At this time, the first reducing gas is supplied to the wafer 200. At the same time, the valve 524 is opened to allow an Ar gas to flow into the gas supply pipe 520. The flow rate of the Ar gas flowing through the gas supply pipe 520 is adjusted by the MFC 522. The Ar gas is supplied into the process chamber 201 together with the first reducing gas and is exhausted through the exhaust pipe 231. At this time, in order to prevent the first reducing gas from entering the nozzle 410, the valve 514 is opened to allow the Ar gas to flow into the gas supply pipe 510. The Ar gas is supplied into the process chamber 201 through the gas supply pipe 310 and the nozzle 410 and is exhausted through the exhaust pipe 231.

At this time, the APC valve 243 is adjusted to set the pressure in the process chamber 201 to fall within the range of 1 to 13000 Pa, for example, to 10000 Pa. The supply flow rate of the first reducing gas controlled by the MFC 322 is, for example, 1 to 50 slm, and may be 15 to 30 slm. Each of the supply flow rates of the Ar gas controlled by the MFCs 512 and 522 is, for example, within the range of 0.1 to 30 slm. At this time, the time for supplying the first reducing gas to the wafer 200 is set to a first time falling within the range of 5 minutes or more and 30 minutes or less, for example, to 20 minutes. By supplying the first reducing gas to the wafer 200 for 5 minutes or longer, it is possible to reduce the second-metal-containing gas adsorbed on the wafer 200. By supplying the first reducing gas to the wafer 200 for 30 minutes or shorter, it is possible to improve the throughput and secure the productivity.

At this time, only the first reducing gas and the Ar gas are flowing into the process chamber 201. The first reducing gas undergoes a substituition reaction with at least a portion of the first second-metal-containing layer formed in step S11. Thus, a second metal layer (second metal film) as a first film is formed, by priority, on the first metal film.

The first reducing gas is, for example, a gas composed of hydrogen (H), and may be a gas composed of hydrogen alone. Specifically, a hydrogen (H₂) gas and a deuterium (D₂) gas may be used.

### (Residual Gas Removal, Step S14)

After forming the second metal layer, the valve 324 is closed to stop the supply of the first reducing gas. Then, the reaction by-products and the first reducing gas unreacted or contributed to the formation of the second metal layer, which remain in the process chamber 201, are removed from the inside of the process chamber 201 by the same processing procedure as in step S12 described above. That is, the inside of the process chamber 201 is purged.

### (Performing a Predetermined Number of Times)

By performing a cycle of sequentially performing the above-described steps S 1 1 to S14 a predetermined number of times (X times where X is an integer of 1 or 2 or more), a first film (second metal film) having a predetermined thickness is formed, by priority, on the first metal film. It is preferable to repeat the above cycle multiple times.

When the structure as described above is formed on the wafer 200, the first film is formed starting from the inner surfaces of the recesses.

### [Process of Forming Modified Layer]

A process of forming a modified layer may be performed between the process of forming the first film and the process of forming the second film. It is possible to make the formation form of the first film and the formation form of the second film different only by changing the condition of the process of forming the first film and the condition of the process of forming the second film. It is also possible to easily make the formation form of the first film and the formation form of the second film different by performing the process of forming the modified layer. When the process of forming the modified layer is performed, the condition of the process of forming the first film and the condition of the process of forming the second film do not have to be made greatly different. For example, there is a condition for performing a substrate processing without making different the temperature setting of the wafer 200 in the process of forming the first film and the temperature setting of the wafer 200 in the process of forming the second film.

An example of the process of forming the modified layer will be described.

### (Supply of Modifying Gas, Step S31)

The valve 334 is opened to allow a modifying gas to flow into the gas supply pipe 330. The flow rate of the modifying gas is adjusted by the MFC 332. The modifying gas is supplied into the process chamber 201 through the gas supply holes 430a of the nozzle 430 and is exhausted through the exhaust pipe 231. At this time, the modifying gas is supplied to the wafer 200. At the same time, the valve 534 may be opened to allow an inert gas such as an Ar gas or the like to flow into the gas supply pipe 530. The flow rate of the Ar gas flowing through the gas supply pipe 530 is adjusted by the MFC 532. The Ar gas is supplied into the process chamber 201 together with the modifying gas and is exhausted through the exhaust pipe 231. At this time, in order to prevent the modifying gas from entering the nozzles 410 and 420, the valves 514 and 524 may be opened to allow the Ar gas to flow into the gas supply pipes 510 and 520. The Ar gas is supplied into the process chamber 201 via the gas supply pipes 310 and 320 and the nozzles 410 and 420 and is exhausted through the exhaust pipe 231.

At this time, the APC valve 243 is adjusted to set the pressure in the process chamber 201 to fall within the range of 1 to 3990 Pa, for example, to 1000 Pa. The supply flow rate of the modifying gas controlled by the MFC 332 is, for example, a flow rate falling within the range of 0.01 to 5.0 slm. The time for supplying the modifying gas to the wafer 200 is set to fall within the range of 1 to 600 seconds, for example.

At this time, the gas flowing in the process chamber 201 is the modifying gas alone, or the modifying gas and the inert gas. By supplying the modifying gas, an adsorption layer (third layer) of the modifying gas is formed on the wafer 200.

The modifying gas is, for example, a gas containing at least one selected from the group of a group 13 element, a group 14 element, and a group 15 element. These elements include, for example, boron (B), silicon (Si), and phosphorus (P). More preferably, the modifying gas is a hydrogen compound. The hydrogen compound containing the Group 13 element includes, for example, a borohydride such as monoborane (BH₃), diborane (B₂H₆) or the like. The hydrogen compound containing the Group 14 element includes a silicon hydride such as monosilane (SiH₄), disilane (Si₂H₆), trisilane (Si₃H₈) or the like. The hydrogen compound containing the Group 15 element includes a phosphorus hydride such as phosphine (PH₃), diphosphine (P₂H₄) or the like. As the modifying gas containing the Group 15 element, in addition to the hydrides, it may be possible to use: an alkylphosphine-based gas such as a trimethylphosphine ((CH₃)3P) gas, a triethylphosphine ((C₂H₅)₃P) gas, a tripropylphosphine ((n-C₃H₇)₃P) gas, a triisopropylphosphine ((i-C₃H₇)₃P) gas, a tributylphosphine ((n-C₄H₉)₃P) gas, a triisobutylphosphine ((i-C₄H₉)₃P) gas, a tri-tert-butylphosphine ((t-C₄H₉)₃P) gas, a tert-butylphosphine (t-C₄H₉PH₂) gas, or the like; an aminophosphine-based gas such as an aminophosphine (NH₂PH₂) gas, a tris(dimethylamino)phosphine ([(CH₃)₂N)]₃P) gas, a bis(dimethylamino)phosphine (PH[N(CH₃)₂]₂) gas, a bis(dimethylamino)chlorophosphine ([(CH₃)₂N]₂PCl) gas, or the like; and a phosphinasamide-based gas such as a bis(dimethylamino)methylphosphine (CH₃P[N(CH₃)₂]₂) gas, a dimethylaminodimethylphosphine ((CH₃)₂PN(CH₃)₂) gas, a diethylaminodiethylphosphine ((C₂H₅)₂PN(C₂H₅)₂) gas, or the like.

The modifying gas is preferably a gas containing P and hydrogen (H). By supplying such a gas to the wafer 200, a modified layer containing at least P is formed on the surface of the wafer 200. Preferably, the modified layer is a layer containing P and H. More preferably, the modified layer is a layer containing molecules of a Group 15 element-containing material or molecules of a Group 15 element-containing material in a partially decomposed state. For example, the first layer formed when PH₃ is used as the Group 15 element-containing material may contain P, H, and PHₓ. In this regard, X is an integer of 3 or less, and PHₓ is, for example, at least one selected from the group of PH, PH₂, and PH₃. In order to form a modified layer containing such a substance, the temperature in the process chamber 201 is preferably a temperature at which a part of the Group 15 element-containing material can be decomposed. For example, when PH₃ is used as the group 15 element-containing material, the temperature in the process chamber 201 is set to fall within the range of 300 degrees C to 650 degrees C.

### (Residual Gas Removal, Step S32)

After a predetermined time has elapsed from the start of the supply of the modifying gas, the valve 334 of the gas supply pipe 330 is closed to stop the supply of the modifying gas. At this time, while keeping the APC valve 243 of the exhaust pipe 231 opened, the inside of the process chamber 201 is vacuum-exhausted by the vacuum pump 246, and the modifying gas unreacted or contributed to the formation of the modified layer, which remains in the process chamber 201, is removed from inside the process chamber 201. That is, the atmosphere in the process chamber 201 is exhausted. By lowering the pressure in the process chamber 201, the modifying gas remaining in the gas supply pipe 330 and the nozzle 430 can be exhausted. By exhausting the modifying gas remaining in the gas supply pipe 330 and the nozzle 430, it is possible to prevent the modifying gas remaining in the gas supply pipe 330 and the nozzle 430 from being supplied into the process chamber 201 in the next step of forming a second film. At this time, the valves 514, 524, and 534 may be kept opened to maintain the supply of the Ar gas into the process chamber 201. The Ar gas can act as a purge gas in addition to acting as a gas that prevent other gases from entering each nozzle. When the Ar gas is supplied as the purge gas, it is possible to enhance the effect of removing the modifying gas unreacted or contributed to the formation of the modified layer, which remains in the process chamber 201, from inside the process chamber 201.

### [Process of Forming Second Layer (Second Film)]

### (Supply of Second-Metal-Containing Gas, Step S21)

The valve 314 is opened to allow a second-metal-containing gas, which is a precursor gas, to flow into the gas supply pipe 310. The second-metal-containing gas used in the process of forming a second film may be the same gas as or different from the second-metal-containing gas used in the above-described process of forming the first film. An example in which the same gas as the second-metal-containing gas used in the process of forming the first film is used will now be described. The flow rate of the second-metal-containing gas is adjusted by the MFC 312. The second-metal-containing gas is supplied into the process chamber 201 through the gas supply holes 410a of the nozzle 410 and is exhausted through the exhaust pipe 231. At this time, the second-metal-containing gas is supplied to the wafer 200. At the same time, the valve 514 is opened to allow an inert gas such as an Ar gas or the like to flow into the gas supply pipe 510. The flow rate of the Ar gas flowing through the gas supply pipe 510 is adjusted by the MFC 512. The Ar gas is supplied into the process chamber 201 together with the second-metal-containing gas and is exhausted through the exhaust pipe 231. At this time, in order to prevent the second-metal-containing gas from entering the nozzle 420, the valve 524 is opened to allow the Ar gas to flow through the gas supply pipe 520. The Ar gas is supplied into the process chamber 201 through the gas supply pipe 320 and the nozzle 420 and is exhausted through the exhaust pipe 231.

At this time, the APC valve 243 is adjusted to set the pressure in the process chamber 201 to fall within the range of 1 to 3990 Pa, for example, to 1000 Pa. The supply amount of the second-metal-containing gas controlled by the MFC 312 is set to be smaller than that in the process of forming the first film. In this regard, the supply amount is adjusted by, for example, adjusting the supply flow rate. The supply flow rate of the second-metal-containing gas is, for example, within the range of 0.1 to 1.0 slm, and may be 0.1 to 0.3 slm. In this way, it is preferable to make the flow rate of the second-metal-containing gas smaller than the flow rate in step S11. Each of the supply flow rates of the Ar gas controlled by the MFCs 512 and 522 is, for example, within the range of 0.1 to 20 slm. The time for supplying the second-metal-containing gas to the wafer 200 is, for example, 1 to 60 seconds, and may be 5 to 20 seconds. The temperature of the wafer 200 is set to 300 to 700 degrees C, and may be 300 to 600 degrees C. When the second-metal-containing layer is formed on each of the first film and the insulating film, it is preferable that the supply amount of the second-metal-containing gas is smaller than that in the process of forming the first film. That is, at least one selected from the group of the supply flow rate of the second-metal-containing gas, the supply time of the second-metal-containing gas, and the pressure inside the process chamber 201 is set to be smaller than in step S11. If the modified layer is formed after the process of forming the first film, the supply amount of the second-metal-containing gas may be the same as that in the process of forming the first film.

Further, by setting the temperature of the wafer 200 (temperature inside the process chamber 201) in the process of forming the second layer (second film) to be lower than the temperature of the wafer 200 in the process of forming the first layer (first film), it is possible to promote formation of the second film on both the first film and the insulating film.

At this time, the gases flowing in the process chamber 201 are only the second-metal-containing gas and the Ar gas. A second second-metal-containing layer is formed on the wafer 200 by supplying the second-metal-containing gas. When the first film and the insulating film are exposed on the wafer 200, the second second-metal-containing layer is formed on each of the first film and the insulating film.

If the process of forming the modified layer is performed after the process of forming the first film, the modified layer formed on the first film and the insulating film reacts with the second-metal-containing gas, and molecules containing a second metal are deposited on the first film and the insulating film. Further, the modified layer and the second-metal-containing gas react with each other, and the elements and molecules contained in the modified layer are desorbed from the modified layer. In this desorption, the elements and molecules constituting the modified layer may be incorporated into the second second-metal-containing layer.

### (Removal of Residual Gas, Step S22)

After forming the second second-metal-containing layer, the valve 314 is closed to stop the supply of the second-metal-containing gas. Then, the reaction by-products and the second-metal-containing gas unreacted or contributed to the formation of the second second-metal-containing layer, which remain in the process chamber 201, are removed from the inside of the process chamber 201 by the same processing procedure as in step S12 described above. That is, the inside of the process chamber 201 is purged.

### (Supply of Second Reducing Gas, Step S23)

After removing the residual gas in the process chamber 201, the valve 324 is opened to allow a second reducing gas to flow into the gas supply pipe 320. The flow rate of the second reducing gas is adjusted by the MFC 322. The second reducing gas is supplied into the process chamber 201 through the gas supply holes 420a of the nozzle 420 and is exhausted through the exhaust pipe 231. At this time, the second reducing gas is supplied to the wafer 200. At the same time, the valve 524 is opened to allow an Ar gas to flow into the gas supply pipe 520.
The flow rate of the Ar gas flowing through the gas supply pipe 520 is adjusted by the MFC 522. The Ar gas is supplied into the process chamber 201 together with the second reducing gas and is exhausted from the exhaust pipe 231. At this time, in order to prevent the second reducing gas from entering the nozzle 410, the valve 514 is opened to allow the Ar gas to flow through the gas supply pipe 510. The Ar gas is supplied into the process chamber 201 through the gas supply pipe 310 and the nozzle 410 and is exhausted through the exhaust pipe 231. The second reducing gas may be the same type as or different from the first reducing gas.

At this time, the APC valve 243 is adjusted to set the pressure inside the process chamber 201 to fall within the range of 1 to 13000 Pa, for example, to 10000 Pa. The supply flow rate of the reducing gas controlled by the MFC 322 is, for example, 1 to 50 slm, and may be 15 to 30 slm. Each of the supply flow rates of the Ar gas controlled by the MFCs 512 and 522 is, for example, within the range of 0.1 to 30 slm.

At this time, the gases flowing into the process chamber 201 are only the second reducing gas and the Ar gas. The second reducing gas undergoes a substitution reaction with at least a portion of the second second-metal-containing layer formed on the wafer 200 in step S21.
Then, a second metal layer as a second film is formed on the wafer 200.

### (Removal of Residual Gas, Step S24)

After forming the second metal layer, the valve 324 is closed to stop the supply of the second reducing gas. Then, the second reducing gas unreacted or contributed to the formation of the second metal layer and the reaction by-products, which remain in the process chamber 201, are removed from the inside of the process chamber 201 by the same processing procedure as in step S14 described above. That is, the inside of the process chamber 201 is purged.

### (Performing a Predetermined Number of Times)

By repeating a cycle of sequentially performing the above steps S21 to S24 a predetermined number of times (Y times where Y is an integer of 1 or 2 or more), a second film having a predetermined thickness is formed on the wafer 200 on which the first film is formed. It is preferable to repeat the above cycle multiple times.

In addition, when the wafer 200 includes a first metal film and an insulating film, the second film is formed on the first film and the insulating film. That is, unlike the first film, the second film is formed over the entire wafer 200.

### (After-Purging and Atmospheric Pressure Restoration)

An Ar gas is supplied from each of the gas supply pipes 510 and 520 into the process chamber 201 and is exhausted through the exhaust pipe 231. The Ar gas acts as a purge gas, whereby the inside of the process chamber 201 is purged with the inert gas, and the gas and reaction by-products remaining in the process chamber 201 are removed from the inside of the process chamber 201 (after-purging). Thereafter, the atmosphere in the process chamber 201 is replaced with the inert gas (purge gas replacement), and the pressure in the process chamber 201 is restored to the atmospheric pressure (atmospheric pressure restoration).

### (Wafer Unloading)

Thereafter, the seal cap 219 is lowered by the boat elevator 115, and the lower end of the outer tube 203 is opened. Then, the processed wafers 200 are unloaded from the lower end of the outer tube 203 to the outside of the outer tube 203 in a state in which the wafers 200 are supported by the boat 217 (boat unloading). Thereafter, the processed wafers 200 is discharged from the boat 217.

### (3) Effects of the Present Embodiment

According to the present embodiment, one or more of the following effects may be obtained.
(a) The second metal-containing films having different properties can be stacked with each other.
(b) When recesses and protrusions are formed on the wafer 200, a metal film is exposed on the inner surfaces of the recesses, and an insulating film is exposed on the side surfaces of the recesses, the second metal-containing films can be formed from the inner surface of the wafer 200. That is, the inside of the recesses can be uniformly filled with the second metal-containing film. In addition, by filling the second metal-containing film from the inner surfaces of the recesses, it is possible to prevent the protrusions (the side walls of the recesses) from collapsing. That is, it is possible to prevent the pattern formed on the wafer 200 from collapsing.
(c) By setting the supply amount of the second-metal-containing gas in the process of forming the first film to be larger than the supply amount of the second-metal-containing gas in the process of forming the second film, in the process of forming the first film, the film formation amount on the bottom surfaces of the recesses (first metal film) can be made larger than the etching amount, and the film formation amount on the side walls of the recesses (insulating film) can be made smaller than the etching amount. That is, the first film can be formed, by priority, on the first metal film. In other words, the first film can be selectively formed on the first metal film. Furthermore, it is possible to improve the selectivity of formation of the first film.
(d) By setting the temperature of the wafer 200 in the process of forming the first film to be higher than the temperature of the wafer 200 in the process of forming the second film, in the process of forming the first film, the film formation amount on the bottom surfaces of the recesses (first metal film) can be made larger than the etching amount, and the film formation amount on the side walls of the recesses (insulating film) can be made smaller than the etching amount. That is, the first film can be formed, by priority, on the first metal film. In other words, the first film can be selectively formed on the first metal film. Furthermore, it is possible to improve the selectivity of formation of the first film.
(e) By performing the process of forming the modified layer after the process of forming the first film, in the process of forming the second film, the film formation amount can be made larger than the etching amount in each portion. That is, the second film can be uniformly formed on the wafer 200 in the process of forming the second film performed after the process of forming the modified layer. In other words, the selectivity in forming the second film can be reduced. Specifically, a layer containing PHₓ is formed as the modified layer by using the PH₃ gas as the modifying gas. A chemical reaction easily occurs between PHₓ and a halide, a layer containing the second metal is formed on the wafer 200, and molecules containing P are desorbed from the modified layer. The molecules containing P may be, for example, phosphoryl chloride (POCl₃). Since such a reaction occurs, the deposition rate of the second metal-containing film can be improved. That is, a state in which the deposition rate exceeds the etching rate can be set. Due to this chemical reaction, the element contained in the modified layer (for example, P) is incorporated into the second metal-containing film (it can also be said that the element contained in the modified layer diffuses into the second metal-containing film).

### (4) Other Embodiments

In the above-described embodiment, there has been described the example in which the film is formed using the batch type substrate processing apparatus that processes a plurality of substrates at a time. The present disclosure is not limited to the embodiment described above, and may be suitably applied to, for example, a case where a film is formed using a single wafer type substrate processing apparatus that processes one or several substrates at a time. Further, in the above-described embodiment, there has been described the example in which the film is formed using the substrate processing apparatus having the hot wall type process furnace. The present disclosure is not limited to the embodiment described above, and may be suitably applied to a case where a film is formed using a substrate processing apparatus having a cold wall type process furnace.

Even when using these substrate processing apparatuses, each process can be performed under the same processing procedures and processing condition as in the above-described embodiment and modifications, and the same effects as in the above-described embodiments and modifications can be obtained.

Preferably, the process recipes (the programs that describe processing procedures, processing condition, etc.) used for forming various thin films are prepared individually (in a multiple number) according to the contents of the substrate processing process (film type, composition ratio, film quality, film thickness, processing procedure, processing condition and the like of the thin film to be formed). When starting the substrate processing process, it is preferable to appropriately select an appropriate process recipe from the plurality of process recipes according to the contents of the substrate processing process. Specifically, the plurality of process recipes individually prepared according to the contents of the substrate processing process is preferably stored (installed) in the memory device 121c of the substrate processing apparatus in advance via a telecommunication line or a recording medium (external memory device 123) in which the process recipe is recorded. Preferably, when starting the substrate processing process, the CPU 121a of the substrate processing apparatus properly selects an appropriate process recipe from the plurality of process recipes stored in the memory device 121c according to the contents of the substrate processing process. With this configuration, it is possible for a single substrate processing apparatus to form thin films of various film types, composition ratios, film qualities, and film thicknesses in a versatile and reproducible manner. In addition, it is possible to alleviate the operator's operation burden (burden in inputting processing procedures, processing condition, etc.) and to quickly start the substrate processing process while avoiding operation errors.

Further, the present disclosure can also be realized by, for example, changing the process recipes of an existing substrate processing apparatus. When changing the process recipes, the process recipes according to the present disclosure may be installed on an existing substrate processing apparatus via a telecommunications line or a recording medium on which the process recipes are recorded, or the input/output device of the existing substrate processing apparatus may be operated to change the process recipes of the existing substrate processing apparatus to the process recipes according to the present disclosure.

The embodiments of the present disclosure have been specifically described above. However, the present disclosure is not limited to the above-described embodiments, and various changes may be made without departing from the gist thereof.

According to the present disclosure in some embodiments, it is possible to improve the film properties of a metal-based film formed on a substrate.

While certain embodiments have been described, these embodiments have been presented by way of example only, and are not intended to limit the scope of the disclosures. Indeed, the embodiments described herein may be embodied in a variety of other forms. Furthermore, various omissions, substitutions, and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate, comprising:
(a) supplying a second-metal-containing gas, which contains a second metal, to the substrate including a first metal film, which contains a first metal, and an insulating film to form a first film containing the second metal on the first metal film; and
(b) supplying the second-metal-containing gas to the substrate to form a second film containing the second metal on the first film and the insulating film.

2. The method of Claim 1, wherein a supply amount of the second-metal-containing gas in (a) is set to be larger than a supply amount of the second-metal-containing gas in (b).

3. The method of Claim 1, wherein a supply flow rate of the second-metal-containing gas in (a) is set to be larger than a supply flow rate of the second-metal-containing gas in (b) or a supply time of the second-metal-containing gas in (a) is set to be larger than a supply time of the second-metal-containing gas in (b).

4. The method of Claim 1, wherein a pressure in a space in which the substrate exists in (a) is set to be larger than a pressure in the space in which the substrate exists in (b).

5. The method of Claim 1, further comprising:
(c) supplying a modifying gas before (b).

6. The method of Claim 5, wherein in (a) and (b), a reducing gas is supplied, and the modifying gas is a compound different from the reducing gas.

7. The method of Claim 5, wherein the modifying gas is a hydrogen compound containing at least one selected from the group of a group 13 element, a group 14 element, and a group 15 element.

8. The method of Claim 5, wherein the modifying gas contains at least one selected from the group of boron, silicon, and phosphorus.

9. The method of Claim 5, wherein the modifying gas contains at least one selected from the group of BH₃, B₂H₆, SiH₄, Si₂H₆, Si₃H₈, and PH₃.

10. The method of any one of Claims 1 to 9, wherein the first metal and the second metal each contains at least one selected from the group of W, Ti, Ru, Co, and Mo.

11. The method of any one of Claims 1 to 9, wherein (a) includes:
(a1) supplying the second-metal-containing gas to the substrate; and
(a2) supplying a first reducing gas to the substrate.

12. The method of Claim 11, wherein (b) includes:
(b1) supplying the second-metal-containing gas to the substrate; and
(b2) supplying a second reducing gas to the substrate.

13. A method of manufacturing a semiconductor device, comprising:
(a) supplying a second-metal-containing gas, which contains a second metal, to a substrate including a first metal film, which contains a first metal, and an insulating film to form a first film containing the second metal on the first metal film; and
(b) supplying the second-metal-containing gas to the substrate to form a second film containing the second metal on the first film and the insulating film.

14. A program that cause, by a computer, a substrate processing apparatus to perform a process comprising:
(a) supplying a second-metal-containing gas to a substrate including a first metal film and an insulating film to form a first film containing a second metal on the first metal film; and
(b) supplying the second-metal-containing gas to the substrate to form a second film containing the second metal on the first film and the insulating film.

15. A substrate processing apparatus, comprising:
a gas supply system configured to supply a second-metal-containing gas to a substrate including a first metal film and an insulating film; and
a controller configured to be capable of controlling the gas supply system so as to perform:
(a) supplying the second-metal-containing gas to the substrate to form a first film containing a second metal on the first metal film; and
(b) supplying the second-metal-containing gas to the substrate to form a second film containing the second metal on the first film and the insulating film.
